# EUROPEAN PATENT APPLICATION

(11) **EP 4 750 249 A1**
(43) Date of publication of application: **27.05.2026**
(21) Application number: 25175228.3
(22) Date of filing: 09.05.2025
(51) Int. Cl.: H10D 30/01, H10D 30/60, H10D 62/10, H10D 62/13, H10D 62/17

(54) **LATERALLY DIFFUSED FIELD EFFECT TRANSISTOR WITH CHANNEL IN FIN REGION AND DRAIN EXTENSION REGION IN PLANAR REGION**

(30) Priority: 26.11.2024 US 202418959819
(71) Applicant: GlobalFoundries U.S. Inc., Malta, NY 12020 (US)
(72) Inventor: Ghattamaneni, Rahul, Malta 12020 (US); Wang, Haiting, Malta 12020 (US)
(74) Representative: Grünecker Patent- und Rechtsanwälte PartG mbB

(57) **Abstract**

A laterally diffused field effect transistor (LDFET) and a related method are disclosed. The LDFET includes a substrate having a fin region and a planar region adjacent to the fin region. The LDFET also includes a source region in the fin region, a drain region in the planar region, a channel gate over the fin region and the planar region, and a drain extension region in the planar region between the source region and the drain region. The use of a substrate with a fin region for the source region and the channel of the channel gate and a planar region for the drain region and the drain extension region provides many of the benefits of both types of substrates for the LDFET.

## Description

### BACKGROUND

The present disclosure relates to transistors, and more specifically, to a laterally diffused field effect transistor with a channel in a fin region and a drain extension region in a planar region, and a related method.

Laterally diffused field effect transistors (LDFETs) are used in, for example, radio frequency (RF) devices.

### SUMMARY

All aspects, examples and features mentioned below can be combined in any technically possible way.

In various aspects, a laterally diffused field effect transistor (LDFET) in accordance with independent claim 1 is provided, advantageous embodiments of the LDFET being defined in the dependent claims 2 to 9. In other aspects, a method in accordance with independent claim 10 is provided, advantageous embodiments thereof being defined in dependent claims 11 to 15.

An aspect of the disclosure provides a laterally diffused field effect transistor (LDFET), the LDFET comprising: a substrate having a fin region and a planar region adjacent to the fin region; a source region in the fin region; a drain region in the planar region; a channel gate over the fin region and the planar region; and a drain extension region in the planar region between the source region and the drain region.

An aspect of the disclosure provides a laterally diffused field effect transistor (LDFET), comprising: a substrate having a fin region and a planar region adjacent to the fin region; a source region in the fin region; a drain region in the planar region; a channel gate over the fin region and the planar region; a channel in the fin region under the channel gate; a drain extension region in the planar region between the channel and the drain region; and a first gate dielectric between the channel gate and the fin region and a second gate dielectric between the channel gate and the planar region.

An aspect of the disclosure provides a method, comprising: forming a substrate having a fin region and a planar region adjacent the fin region; forming a source region in the fin region; forming a drain region in the planar region; and forming a channel gate over the fin region and the planar region, creating a channel in the fin region under the channel gate and a drain extension region in the planar region between the channel and the drain region, wherein forming the channel gate includes forming a first gate dielectric between a body of the channel gate and the fin region and forming a second gate dielectric between the body of the channel gate and the planar region.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a schematic top-down view of a substrate according to embodiments of the disclosure;
FIG. 2 shows a cross-sectional view of a preliminary structure for a laterally diffused field effect transistor (LDFET) according to embodiments of the disclosure;
FIG. 3 shows a cross-sectional view of forming source/drain regions for an LDFET according to embodiments of the disclosure;
FIG. 4 shows a cross-sectional view of forming a gate dielectric for an LDFET according to embodiments of the disclosure;
FIG. 5 shows a cross-sectional view of forming a channel gate and an LDFET according to other embodiments of the disclosure;
FIG. 6 shows a cross-sectional view of an LDFET according to other embodiments of the disclosure;
FIG. 7 shows a cross-sectional view of forming a gate dielectric for an LDFET according to other embodiments of the disclosure;
FIG. 8 shows a cross-sectional view of forming a channel gate and an LDFET according to other embodiments of the disclosure;
FIG. 9 shows a cross-sectional view of an LDFET according to other embodiments of the disclosure;
FIG. 10 shows a cross-sectional view of an LDFET according to other embodiments of the disclosure; and
FIG. 11 shows a cross-sectional view of an LDFET including interconnects according to various embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a laterally diffused field effect transistor (LDFET) and a related method. The LDFET includes a substrate having a fin region and a planar region adjacent to the fin region. The LDFET also includes a source region in the fin region, a drain region in the planar region, a channel gate over the fin region and the planar region, and a drain extension region in the planar region between the source region and the drain region. The use of a substrate with a fin region for the source region and the channel of the channel gate and a planar region for the drain region and the drain extension region provides many of the benefits of both types of substrates for the LDFET. For example, the ability to make thicker gate dielectric in the planar region allows for higher breakdown voltage, e.g., 10-15 Volt increase, and drain voltage compared to LDFETs that use just fins. Yet, the channel gate being over a fin region allows the same drive current control present in fin-only LDFETs. The use of the planar region also reduces fixed charges normally present in the drain extension region in fin-only LDFETs that decrease linear current (Idlin) and increase on resistance (Ron). The planar region also reduces or eliminates fixed charges that normally form at a bottom of the fins in the drain region of a fin-only device, thus lowering hot carrier injection (HCI).

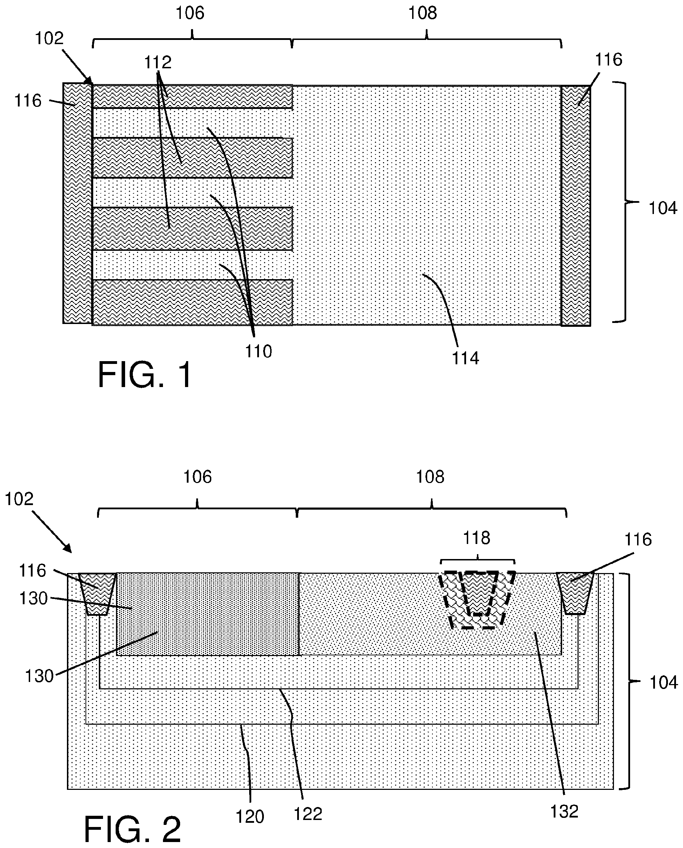

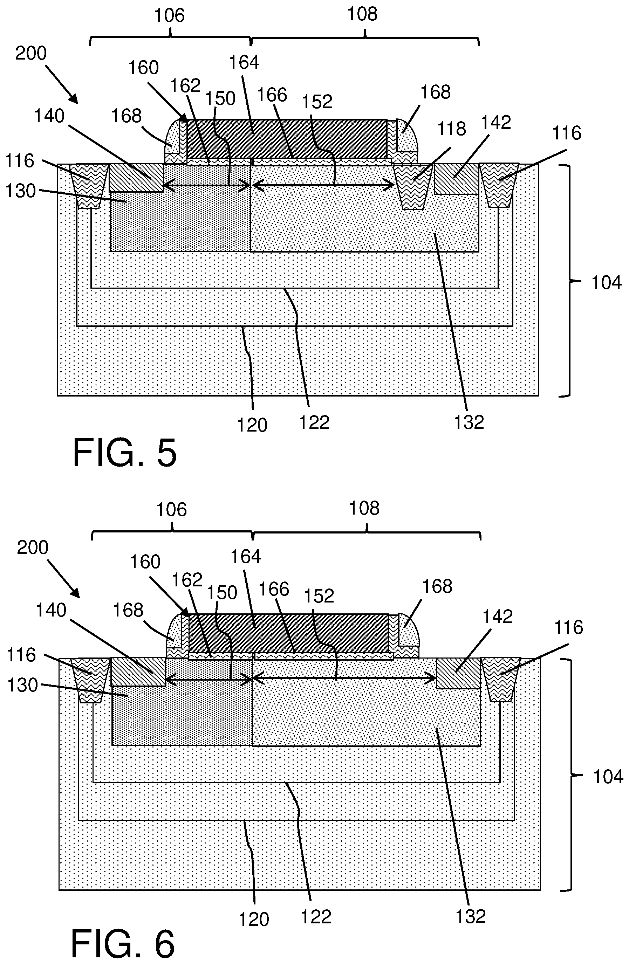

FIGS. 1-11 show various views of a method to form a laterally diffused metal-oxide field effect transistor (LDFET) (hereafter "LDFET 200" for brevity) according to various embodiments of the disclosure. LDFET 200 (FIGS. 5, 6, 8-11), unlike current LDFETs, is implemented over a substrate 104 including a fin region 106 and a planar region 108, rather than just one or the other type of substrate. While shown with fin region 106 and planar region 108 in a certain orientation, it will be recognized that teachings of the disclosure may be implemented in other orientations than that shown.

FIG. 1 shows a schematic top-down view of a preliminary structure 102 including a semiconductor substrate 104. More particularly, FIG 1 shows forming a substrate 104 having a fin region 106 and a planar region 108 adjacent fin region 106. Semiconductor substrate 104 may include but is not limited to silicon, germanium, silicon germanium, silicon carbide, and those consisting essentially of one or more III-V compound semiconductors having a composition defined by the formula Al_{X1}Ga_{X2}In_{X3}As_{Y1}P_{Y2}N_{Y3}Sb_{Y4}, where X1, X2, X3, Y1, Y2, Y3, and Y4 represent relative proportions, each greater than or equal to zero and X1+X2+X3+Y1+Y2+Y3+Y4=1 (1 being the total relative mole quantity). Other substrates are also possible. Furthermore, a portion or entire semiconductor substrate 104 may be strained. In certain embodiments, semiconductor substrate 104 may include a p-type dopant, which may include but is not limited to: boron (B), indium (In) and gallium (Ga). P-type dopants are elements introduced to semiconductor material to generate a free hole by "accepting" electron from semiconductor atom and "releasing" the hole at the same time. The dopant may be introduced to semiconductor substrate 104 in any now known or later developed fashion, e.g., in-situ doping during formation or ion implanting. As the doping technology used in this setting is well known in the art, no further detail is required.

Semiconductor substrate 104 may be formed using any now known or later developed technology to create a fin region 106 and a planar region 108 (also known as a bulk region) adjacent fin region 106. In one non-limiting example, a self-aligned double patterning (SADP) process is used to define fins 110 within semiconductor substrate 104. SADP, also known as sidewall image transfer (SIT), uses a sacrificial structure (e.g., a mandrel, typically composed of a polycrystalline silicon), and a sidewall spacer (such as atomic layer deposited (ALD) silicon dioxide or silicon nitride, for example) having a dimension less than that permitted by current lithographic ground rules formed on the sides of the mandrel (e.g., via oxidization or film deposition and etching). After removal of the mandrel, the remaining sidewall spacer is used as a hard mask (HM) to etch the layer(s) below, for example, with a directional reactive ion etch (RIE). Prior to the RIE etch, a new etch blocking layer is patterned to block what will eventually be planar region 108 (for eventual drain extension region 152 and drain region 142) in LDFET 200 (FIGS. 5, 6, 8-10). The RIE process is then completed to etch the pattern into semiconductor substrate 104 to form fins 110 in fin region 106 but leave planar region 108 blocked. Subsequently, the space between fins 110 is filled using a dielectric material 112, e.g., an oxide, and the etch blocking layer is removed, resulting in fin region 106 adjacent planar region 108. Other techniques for forming fins 110 in fin region 106 adjacent planar region 108 are also possible. Fins 110 are contiguous with a bulk semiconductor 114 of planar region 108 (e.g., so that top surfaces of fins 110 and planar region 108 are essentially co-planar).

FIG. 2 shows a cross-sectional view of preliminary structure 102 configured for forming LDFET 200 (FIGS. 5, 6, 8-11) after a number of additional steps. As illustrated, preliminary structure 102 may also include any now known or later developed trench isolation(s) 116 in substrate 104 to electrically isolate the eventually formed LDFET 200 (FIGS. 5, 6, 8-10) from other devices. Trench isolation(s) 116 may be formed as, for example, shallow trench isolations. As will be further described herein, in certain embodiments, as shown in FIG. 2, an additional trench isolation 118 may be formed within planar region 108 that will eventually be part of LDFET 200 (FIGS. 5, 8, 10 and 11). As will be described further herein, forming trench isolation 118, as shown, positions it in planar region 108 between drain extension region 152 and drain region 142 of LDFET 200 (FIGS. 5, 8, 10, 11). Trench isolation 118 may be formed as a shallow trench isolation (shown with smaller dashed trapezoid) similar to trench isolation(s) 116 or as deep trench isolation (DTI) (shown with larger dashed trapezoid). In the latter case, trench isolation 118 is deeper than (shallow) trench isolation(s) 116. In one non-limiting example, trench isolation 118 may have a depth of 200 nanometers compared to trench isolations 116 having a depth of 100-120 nanometers. However, any depth from 80-400 nanometers may be possible for trench isolations 116, 118. Note, where trench isolation 118 is provided, a bottom thereof is above a bottom of doped region 132, so drain extension region 152 still extends/provides a conductive path to drain region 142.

In any event, trench isolations 116 include a trench etched into semiconductor substrate 104 and filled with an insulating material such as oxide, to isolate one region of the substrate from an adjacent region of the substrate. One or more transistors and/or passive devices may be disposed within an area isolated by trench isolation(s) 116. Where trench isolation(s) 116, 118 are shallow trench isolations, they may be formed of any currently known or later developed substance for providing electrical insulation, and as examples may include but not limited to: silicon oxide, fluorinated silicon oxide (FSG), hydrogenated silicon oxycarbide (SiCOH), porous SiCOH, boro-phospho-silicate glass (BPSG), or combinations thereof. In one non-limiting example, the material for shallow trench isolations may include a flowable chemical vapor deposited (FCVD) oxide. Where trench isolation 118 is deeper, it may include, for example, an oxide formed by a high aspect ratio process (HARP) thermal, non-plasma based chemical vapor depositing (CVD) process or a local oxidation of silicon (LOCOS) process, the latter of which will be described further herein. Other insulation materials and formation methods may also be possible.

As shown in FIG. 2, preliminary structure 102 may also include a plurality of doped wells 120, 122 in semiconductor substrate 104. For purposes of description, doped wells 120, 122 include but are not limited to an n-type doped well (hereafter "n-well") 120 surrounding a p-typed doped well (hereafter "p-well") 122. Preliminary structure 102 formation also includes forming doped regions 130, 132. Doped region 130 may take the form of a p-type doped well, and doped region 132 may take the form of a n-type doped well. Doped regions 130, 132 will be referenced as regions to differentiate from p-well 122 and n-well 120, respectively; it is recognized that all are doped wells. N-well 120, p-well 122 and doped regions 130, 132 may be formed using any now known or later developed semiconductor doping technique. For example, n-well 120, p-well 122 and doped regions 130, 132 may be formed by mask-directed doping by ion implantation followed by an anneal to drive in the dopants, in-situ doping during formation of substrate 104, and/or any other now known or later developed doping process. As noted, n-well 120 and doped region 132 may be doped with an n-type dopant. N- type dopants may include but are not limited to: phosphorous (P), arsenic (As), or antimony (Sb). The n-type dopant of doped region 132 may be the same as n-well 120, but with a higher dopant concentration. Alternatively, the n-type dopants of each structure may be different. P-well 122 and doped region 130 may be doped with a p-type dopant. The p-type dopant of p-well 122 may be the same as semiconductor substrate 104, but with a higher dopant concentration. Similarly, the p-type dopant of doped region 130 may be the same as p-well 122 and/or semiconductor substrate 104, but with a higher dopant concentration. Alternatively, the p-type dopants of each structure may be different.

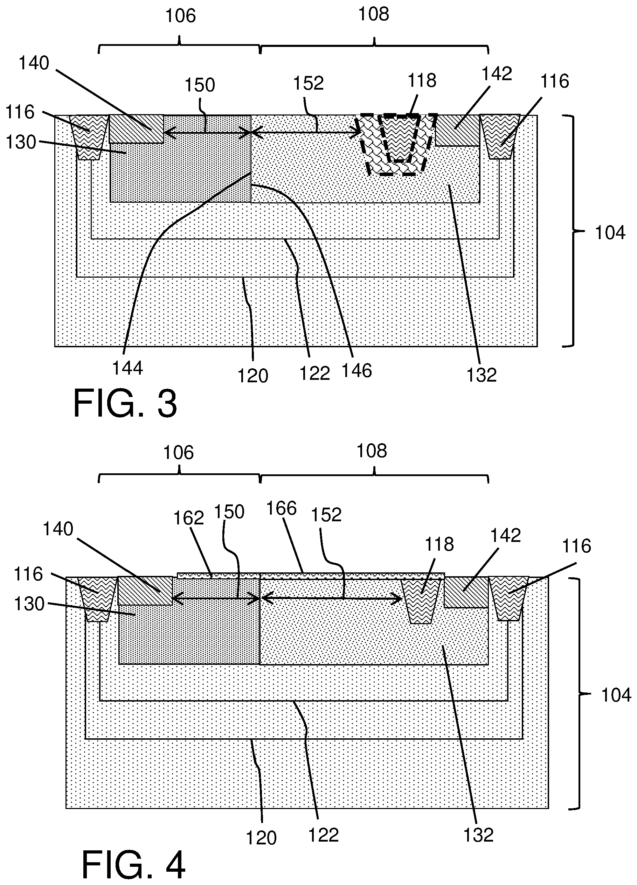

FIG. 3 shows a cross-sectional view of forming a source region 140 in fin region 106 and forming a drain region 142 in planar region 108 configured for LDFET 200 (FIGS. 5, 6, 8-11) in semiconductor substrate 104. Source/drain regions 140, 142 may be formed using any now known or later developed semiconductor doping technique. For example, source/drain regions 140, 142 may be formed by mask-directed doping by ion implantation (not shown) followed by an anneal to drive in the dopants. Source/drain regions 140, 142 may be doped with any n-type dopant as described herein. Doped region 130 (e.g., a p-well) extends around source region 140 (e.g., an N+ doped region) in semiconductor substrate 104 and doped region 132 (e.g., an n-well) extends around drain region 142 (e.g., an N+ doped region) in semiconductor substrate 104, respectively.

As understood in the field, a space between source region 140 and an edge 144 of doped region 132 will eventually define a channel 150 of the device; and a space between an edge 146 of doped region (n-well) 130 and either drain region 142 or trench isolation 118, where latter is present, will eventually define a drain extension region 152 (also known as a drift region). While edges 144, 146 are shown as co-linear, that is not necessary in all instances. It is understood that LDFET 200 (FIGS. 5, 6, 8-11) may also be formed in a manner that two transistors share a single drain region 142 and doped region (n-well) 132. In this case, preliminary structure 102 would include another source region 140 and doped region 130 mirrored to the right of drain region 142. Again, where trench isolation 118 is provided, a bottom thereof is above a bottom of doped region 132, so drain extension region 152 still extends/provides a conductive path to drain region 142.

FIGS. 4 and 5 show cross-sectional views of forming a channel gate 160 (FIG. 5) over fin region 106 and planar region 108. Channel 150 in fin region 106 is under channel gate 160 and drain extension region 152 in planar region 108 between channel 150 and drain region 142 (perhaps around trench isolation 118, if present as in FIG. 5). In FIGS. 4 and 5, trench isolation 118 is shown as a shallow trench isolation, which may be formed in the same manner and at the same time as trench isolation(s) 116. As shown in FIGS. 4 and 5, forming channel gate 160 may include forming a first gate dielectric 162 between a body 164 of channel gate 160 and fin region 106 and forming a second gate dielectric 166 between body 164 of channel gate 160 and planar region 108. First and second gate dielectric 162, 166 may include any now known or later developed gate dielectric appropriate for an LDMOS transistor including but not limited to: silicon oxide, hafnium silicate, hafnium oxide, zirconium silicate, zirconium oxide, silicon nitride, silicon oxynitride, high-k material or any combination of these materials. In certain embodiments, first and second gate dielectric 162, 166 include silicon oxide.

First and second gate dielectric 162, 166 may be formed in different ways according to different embodiments of the disclosure. In certain embodiments, shown in FIGS. 4-5, forming first gate dielectric 162 and second gate dielectric 166 includes using an in-situ steam generated (ISSG) oxide process in fin region 106 and planar region 108. The ISSG oxide process may include any now known or later developed wet oxidation in which steam is generated in close proximity to the wafer surface. As indicated in FIG. 4, the ISSG oxide, e.g., of first and second gate dielectrics 162, 166, has a uniform thickness. In one non-limiting example, the ISSG oxide may have a thickness of 3.4 nanometers with no more than +/- 0.5 nanometers difference in thickness.

FIG. 5 shows forming body 164 of channel gate 160. Channel gate 160 may be formed by forming a polysilicon gate body layer (for body 164) over at least gate dielectrics 162, 166 over semiconductor substrate 104. The polysilicon gate body layer may include any now known or later developed polysilicon material appropriate for a gate body in a LDFET 200 (FIGS. 5, 6, 8-11), i.e., a channel gate or a split gate field plate thereof. The polysilicon gate body layer may be formed by any appropriate deposition technique, e.g., ALD. Subsequently, a patterned mask may be formed over an area in which body 164 of channel gate 160 is desired and etching may be performed, stopping on substrate 104 and/or gate dielectrics 162, 166. Note, gate dielectrics 162, 166 may also be patterned during this process so they are only under body 164. Any appropriate etching process appropriate for the material of body 164 and/or gate dielectrics 162, 166 can be used, e.g., a reactive ion etch (RIE). After etching, the mask may be removed using any appropriate mask removal process for the mask material used. Conventional spacers 168 may be formed along sidewalls of channel gate 160, e.g., body 164. Spacers 168 may include any now known or later developed spacer material, e.g., silicon nitride and/or silicon oxide, and may be formed with any now known or later developed process.

Although not shown, it is understood that a split gate field plate may also be formed with channel gate 160, e.g., in a layer over channel gate and between channel gate 160 and drain region 142. In addition, while source/drain regions 140, 142 and doped regions 130, 132 were described as formed prior to channel gate 160, it is understood that source/drain regions 140, 142 and/or doped region(s) 130, 132 may be formed after channel gate 160 formation, e.g., using spacers 168 to self-align source/drain regions 140, 142 and/or doped region(s) 130, 132.

FIG. 5 shows an LDFET 200 according to embodiments of the disclosure. As shown in FIGS. 1 and 5, LDFET 200 includes substrate 104 having fin region 106 and planar region 108 adjacent to fin region 106. As shown in FIG. 5, source region 140 is in fin region 106 and drain region 142 is in planar region 108. Channel gate 160 is over fin region 106 and planar region 108, creating channel 150. Drain extension region 152 is in planar region 108 between source region 140 and drain region 142 (perhaps around trench isolation 118, if present). More particularly, drain extension region 152 is between channel 150 and drain region 142 (perhaps around trench isolation 118, if present). LDFET 200 also includes a gate dielectric(s) 162, 166 between channel gate 160 and fin region 106 and planar region 108, respectively. In FIG. 5, first and second gate dielectrics 162, 166 include an in-situ steam generated (ISSG) oxide and have a same, uniform thickness over fin region 106 and planar region 108. In the FIG. 5 embodiments, LDFET 200 also includes trench isolation 118 in planar region 108 between channel 150 and drain extension region 152 adjacent drain region 142. Consequently, drain extension region 152 extends from channel 150 to trench isolation 118. As shown, channel gate 160 may extend partially over trench isolation 118.

The use of substrate 104 with fin region 106 for source region 140 and channel 150 of channel gate 160 and planar region 108 for drain region 142 and drain extension region 152 provides many of the benefits of both types of substrates for LDFET 200. For example, the use of planar region 108 reduces fixed charges normally present in drain extension region 152 in fin-only LDFETs that increase linear current (Idlin) and increase on resistance (Ron). Planar region 108 also reduces or eliminates fixed charges that normally form at a bottom of the fins in drain region 142 of a fin-only device, thus lowering hot carrier injection (HCI).

FIG. 6 shows a cross-sectional view of LDFET 200 according to another embodiment. LDFET 200 in FIG. 6 is identical to that in FIG. 5 except trench isolation 118 is omitted. Consequently, drain extension region 152 extends from channel 150 to drain region 142, so it is longer than in FIG. 5. The longer drain extension region 152 with higher drain voltage helps decrease electrical fields gradually from drain region 142, i.e., with no abrupt drop in voltage that could cause a higher breakdown voltage.

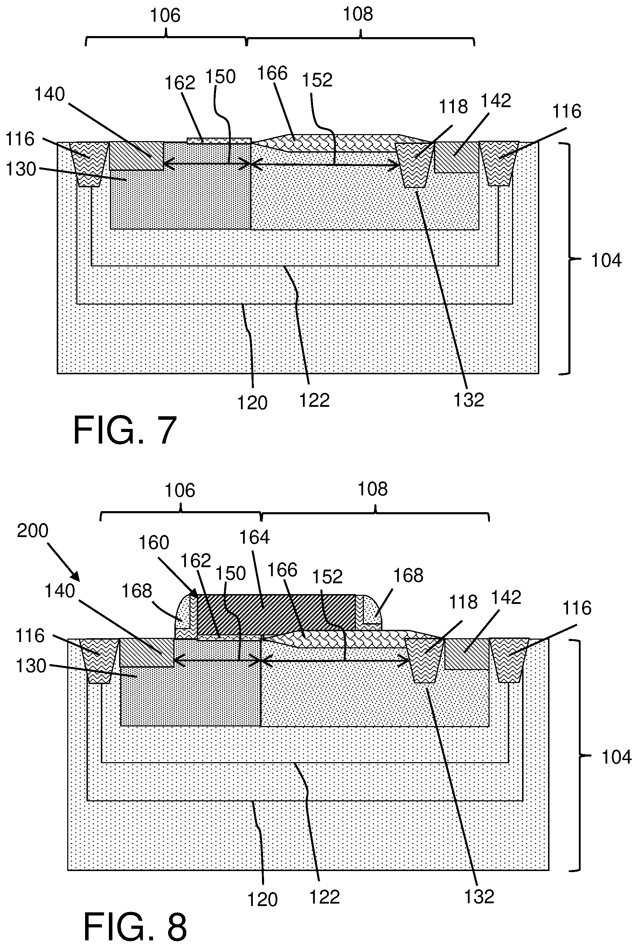

FIGS. 7 and 8 show cross-sectional views of forming first and second gate dielectrics 162, 166 and gate channel 160 over fin region 106 and planar region 108, according to other embodiments. In this embodiment, second gate dielectric 166 in planar region 108 is thicker than first gate dielectric 162 in fin region 106, i.e., based on a maximum thickness of each. In certain embodiments, shown in FIG. 7, forming first gate dielectric 162 includes using an in-situ steam generated (ISSG) oxide process in fin region 106, and forming second gate dielectric 166 includes using a local oxidation of silicon (LOCOS) oxide process in planar region 108. As noted previously, the ISSG oxide process may include any now known or later developed wet oxidation in which steam is generated in close proximity to the wafer surface. The LOCOS oxide process may include any now known or later developed LOCOS process. As understood in the field, the LOCOS process is mask directed, e.g., using a nitride mask patterned to exposed areas in which the LOCOS process is performed. The LOCOS is a thermal oxidation process, e.g., furnace driven, carried out through the exposed areas of the patterned mask. The ISSG oxide may act as an initial pad oxide for the LOCOS oxide. As indicated in FIG. 7, the ISSG oxide, e.g., of first gate dielectric 162, has a uniform thickness where provided, and the LOCOS oxide, e.g., of second gate dielectric 166, has a non-uniform or variable thickness across its width. In one non-limiting example, the LOCOS oxide may have a thickness ranging between 0.5 to 20 nanometers. In the latter case, the LOCOS oxide may have, for example, a bulbous configuration extending through an opening in the mask (not shown) used. Once the LOCOS oxide is formed, the nitride mask is removed using any appropriate removal process. The result of the different oxide formation processes, as shown in FIGS. 7 and 8, is that second gate dielectric 166 over planar region 108 is thicker than first gate dielectric 162 over fin region 106, which allows for a higher breakdown and drain region voltage compared to fin-only LDFETs.

FIG. 8 shows forming channel gate 160 over fin region 106 and planar region 108, creating channel 150 in fin region 106 under channel gate 160 and drain extension region 152 in planar region 108 between channel 150 and drain region 142. Forming channel gate 160 includes forming body 164 of channel gate 160 in a similar fashion as described relative to FIG. 5. Channel gate 160 may be formed by forming a polysilicon gate body layer (for body 164) over at least gate dielectrics 162, 166 over semiconductor substrate 104, and patterning the layer. Although not shown, it is understood that a split gate field plate may also be formed with channel gate 160.

FIG. 8 also shows LDFET 200 according to other embodiments of the disclosure. As shown in FIGS. 1 and 8, LDFET 200 includes substrate 104 having fin region 106 and planar region 108 adjacent to fin region 106. As shown in FIG. 8, source region 140 is in fin region 106 and drain region 142 is in planar region 108. Channel gate 160 is over fin region 106 and planar region 108, creating channel 150. Drain extension region 152 is in planar region 108 between source region 140 and trench isolation 118. More particularly, drain extension region 152 is between channel 150 and drain region 142, and around trench isolation 118. LDFET 200 also includes first and second gate dielectrics 162, 166 between channel gate 160 and fin region 106 and planar region 108, respectively. In FIG. 8, first and second gate dielectric 162, 166 have different thicknesses. More particularly, second gate dielectric 166 over planar region 108 is thicker than first gate dielectric 162 over fin region 106. First gate dielectric 162 includes ISSG oxide in fin region 106 and second gate dielectric 166 includes LOCOS oxide in planar region 108. As noted, the ISSG oxide (first gate dielectric 162) has a uniform thickness and the LOCOS oxide (second gate dielectric 166) has a non-uniform or variable thickness. LDFET 200 in FIG. 8 also includes trench isolation 118 in planar region 108 between drain extension region 152 and drain region 142, and channel gate 160 may extend partially over trench isolation 118.

The use of substrate 104 with fin region 106 for source region 140 and channel 150 of channel gate 160 and planar region 108 for drain region 142 and drain extension region 152 provides many of the benefits of both types of substrates for LDFET 200. For example, the ability to make thicker gate dielectric 166 in planar region 108 allows for higher breakdown voltage, e.g., 10-15 Volt increase, and drain voltage compared to LDFETs that use just fins. Yet, channel 150 being over fin region 106 allows the same drive current control present in fin-only LDFETs. The use of planar region 108 also reduces fixed charges normally present in the drain extension region 152 in fin-only LDFETs that increase linear current (Idlin) and increase on resistance (Ron). As noted, planar region 108 also reduces or eliminates fixed charges that normally form at a bottom of the fins in drain region 142 of a fin-only device, thus lowering hot carrier injection (HCI).

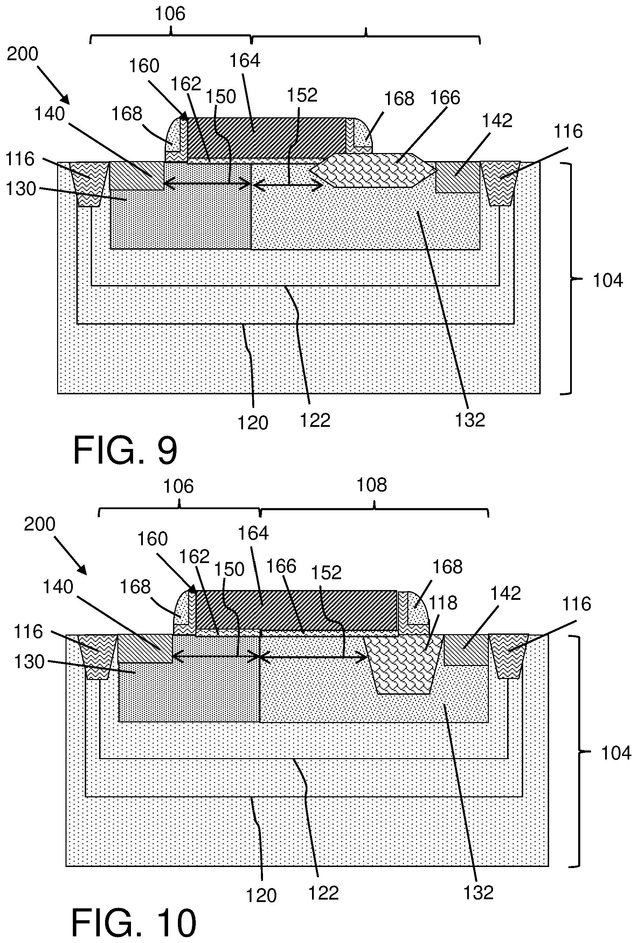

FIG. 9 shows a cross-sectional view of LDFET 200 according to additional embodiments of the disclosure. FIG. 9 is similar to FIG. 8 except LDFET 200 does not include trench isolation 118 in planar region 108. In this embodiment, the LOCOS oxide, second gate dielectric 166 replaces trench isolation 118, and second gate dielectric 166 can have a non-uniform or variable thickness in a range of 0.5-300 nanometers, which is thicker than in FIG. 8. Here, drain extension region 152 extends from channel 150 to second gate dielectric 166, so it is shorter than in FIG. 8. More particularly, in FIG. 9, first gate dielectric 162 includes ISSG oxide in fin region 106 (and part of planar region 108) and second gate dielectric 166 includes LOCOS oxide in planar region 108 (partially under channel gate 160). As noted, the ISSG oxide has a uniform thickness and the LOCOS oxide has a non-uniform or variable thickness.

FIG. 10 shows a cross-sectional view of LDFET 200 according to yet further embodiments of the disclosure. FIG. 10 is identical to FIG. 5 except trench isolation 118 in planar region 108 between drain extension region 152 and drain region 142 includes a deep trench isolation (DTI), e.g., between 150-400 nanometers deep, in planar region 108 between drain extension region 152 and drain region 142. In addition, trench isolation 118 includes a LOCOS oxide. Again, where trench isolation 118 is provided, a bottom thereof is above a bottom of doped region 132, so drain extension region 152 still extends/provides a conductive path to drain region 142. As shown, channel gate 160 may extend partially over trench isolation 118.

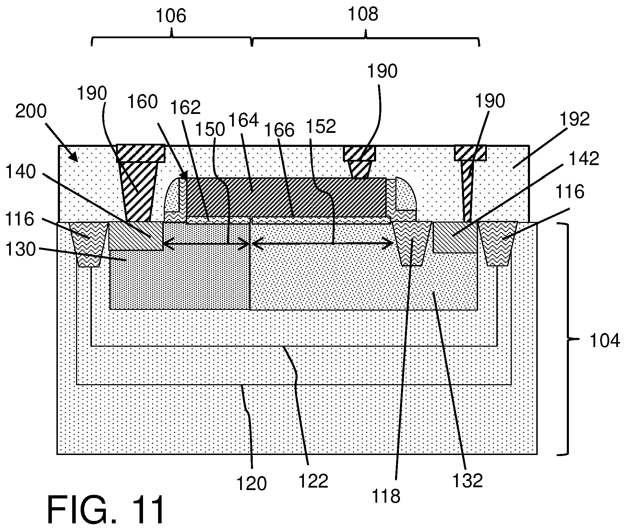

FIG. 11 show cross-sectional views of various subsequent processes relative to LDFET 200, such as forming interconnects 190 to source/drain regions 140, 142, channel gate 160 and any split gate field plate (not shown). FIG. 11 is applied to the FIG. 5 embodiment, but those with skill in the art will recognize the processes are equally applicable to the FIGS. 6 and 8-10 embodiments of LDFET 200. Any now known or later developed salicidation process may be performed on source/drain regions 140, 142, channel gate 160 and/or split gate field plate (not shown). Silicide may be formed using any now known or later developed technique, e.g., performing an in-situ pre-clean, depositing a metal such as titanium, nickel, cobalt, etc., annealing to have the metal react with silicon or polysilicon, and removing unreacted metal. Interconnects 190 can be formed using any now known or later developed techniques such as but not limited to depositing one or more interlayer dielectric (ILD) layers 192, forming openings for contacts and/or wires, depositing a refractory metal liner and conductor, and planarizing. ILD layers 192 may include any currently-known or later developed substance for providing electrical insulation, and as examples may include: silicon nitride, silicon oxide, fluorinated silicon oxide (FSG), hydrogenated silicon oxycarbide (SiCOH), porous SiCOH, boro-phospho-silicate glass (BPSG), silsesquioxanes, carbon (C) doped oxides (i.e., organosilicates) that include atoms of silicon (Si), carbon (C), oxygen (O), and/or hydrogen (H), thermosetting polyarylene ethers, a spin-on silicon-carbon containing polymer material, near frictionless carbon (NFC), or layers thereof.

While LDFET 200 has been described herein with a particular dopant configuration to form a certain polarity device, it will be recognized that the dopant configurations can be switched or otherwise modified to create a different polarity device or the same type polarity device but with different operational characteristics.

Embodiments of the disclosure provide various technical and commercial advantages, examples of which are discussed herein. As noted, the use of a substrate with a fin region for the source region and the channel of the channel gate and a planar region for the drain region and the drain extension region provides many of the benefits of both types of substrates for the LDFET. For example, the ability to make thicker gate dielectric in the planar region allows for higher breakdown voltage, e.g., 10-15 Volt increase, and drain voltage compared to LDFETs that use just fins. Yet, the channel being over a fin region allows the same drive current control present in fin-only LDFETs. The planar region reduces fixed charges normally present in the drain extension region in fin-only LDFETs that increase linear current (Idlin) and increase on resistance (Ron). Planar region 108 also reduces or eliminates fixed charges that normally form at a bottom of the fins in drain region 142 of a fin-only device, thus lowering hot carrier injection (HCI).

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, a laterally diffused field effect transistor (LDFET) and a related method are disclosed. The LDFET includes a substrate having a fin region and a planar region adjacent to the fin region. The LDFET also includes a source region in the fin region, a drain region in the planar region, a channel gate over the fin region and the planar region, and a drain extension region in the planar region between the source region and the drain region. The use of a substrate with a fin region for the source region and the channel of the channel gate and a planar region for the drain region and the drain extension region provides many of the benefits of both types of substrates for the LDFET.

The following embodiments are explicitly disclosed.
Embodiment 1:
   A laterally diffused field effect transistor (LDFET), comprising:
   a substrate having a fin region and a planar region adjacent to the fin region;
   a source region in the fin region;
   a drain region in the planar region;
   a channel gate over the fin region and the planar region; and
   a drain extension region in the planar region between the source region and the drain region.
Embodiment 2:
   The LDFET of embodiment 1, further comprising a first gate dielectric between the channel gate and the fin region and a second gate dielectric between the channel gate and the planar region.
Embodiment 3:
   The LDFET of embodiment 2, wherein the first and second gate dielectrics include an in-situ steam generated (ISSG) oxide and have a same, uniform thickness over the fin region and the planar region.
Embodiment 4:
   The LDFET of embodiment 2 or 3, further comprising a trench isolation (TI) in the planar region between the drain extension region and the drain region, wherein the channel gate extends partially over the trench isolation.
Embodiment 5:
   The LDFET of one of embodiments 2 to 4, further comprising a deep trench isolation (DTI) in the planar region between the drain extension region and the drain region, wherein the channel gate extends partially over the DTI, wherein the DTI includes a local oxidation of silicon (LOCOS) oxide.
Embodiment 6:
   The LDFET of one of embodiments 2 to 5, wherein the second gate dielectric is thicker than the first gate dielectric.
Embodiment 7:
   The LDFET of embodiment 6, wherein the first gate dielectric includes an in-situ steam generated (ISSG) oxide in the fin region and the second gate dielectric includes a local oxidation of silicon (LOCOS) oxide in the planar region, wherein the ISSG oxide has a uniform thickness and the LOCOS oxide has a non-uniform thickness.
Embodiment 8:
   The LDFET of embodiment 7, further comprising a trench isolation (TI) in the planar region between the drain extension region and the drain region, wherein the channel gate extends partially over the trench isolation.
Embodiment 9:
   A laterally diffused field effect transistor (LDFET), comprising:
   a substrate having a fin region and a planar region adjacent to the fin region;
   a source region in the fin region;
   a drain region in the planar region;
   a channel gate over the fin region and the planar region;
   a channel in the fin region under the channel gate;
   a drain extension region in the planar region between the channel and the drain region; and
   a first gate dielectric between the channel gate and the fin region and a second gate dielectric between the channel gate and the planar region.
Embodiment 10:
   The LDFET of embodiment 9, wherein the first and second gate dielectrics include an in-situ steam generated (ISSG) oxide and have a same, uniform thickness over the fin region and the planar region.
Embodiment 11:
   The LDFET of embodiment 10, further comprising a trench isolation (TI) in the planar region between the drain extension region and the drain region, wherein the channel gate extends partially over the trench isolation.
Embodiment 12:
   The LDFET of one of embodiments 9 to 11, further comprising a deep trench isolation (DTI) in the planar region between the drain extension region and the drain region, wherein the channel gate extends partially over the DTI, wherein the DTI includes a local oxidation of silicon (LOCOS) oxide.
Embodiment 13:
   The LDFET of one of embodiments 9 to 12, wherein the second gate dielectric is thicker than the first gate dielectric.
Embodiment 14:
   The LDFET of embodiment 13, wherein the first gate dielectric includes an in-situ steam generated (ISSG) oxide in the fin region and the second gate dielectric includes a local oxidation of silicon (LOCOS) oxide in the planar region, wherein the ISSG oxide has a uniform thickness and the LOCOS oxide has a non-uniform thickness.
Embodiment 15:
   The LDFET of embodiment 13 or 14, further comprising a trench isolation (TI) in the planar region between the drain extension region and the drain region, wherein the channel gate extends partially over the trench isolation.
Embodiment 16:
   A method, comprising:
   forming a substrate having a fin region and a planar region adjacent the fin region;
   forming a source region in the fin region;
   forming a drain region in the planar region; and
   forming a channel gate over the fin region and the planar region, creating a channel in the fin region under the channel gate and a drain extension region in the planar region between the channel and the drain region,
   wherein forming the channel gate includes forming a first gate dielectric between a body of the channel gate and the fin region and forming a second gate dielectric between the body of the channel gate and the planar region.
Embodiment 17:
   The method of embodiment 16, wherein forming the first gate dielectric and the second gate dielectric includes using an in-situ steam generated (ISSG) oxide process in the fin region and the planar region.
Embodiment 18:
   The method of embodiment 16 or 17, wherein the second gate dielectric in the planar region is thicker than the first gate dielectric in the fin region.
Embodiment 19:
   The method of embodiment 18, wherein forming the first gate dielectric includes using an in-situ steam generated (ISSG) oxide process in the fin region, and forming the second gate dielectric includes using a local oxidation of silicon (LOCOS) oxide process in the planar region.
Embodiment 20:
   The method of one of embodiments 16 to 19, further comprising forming a trench isolation in the planar region between the drain extension region and the drain region.
Embodiment 21:
   The method of one of embodiments 16 to 20, wherein the LDFET of one of embodiments 1 to 15 is formed.

## Claims

1. A laterally diffused field effect transistor (LDFET), comprising:
a substrate having a fin region and a planar region adjacent to the fin region;
a source region in the fin region;
a drain region in the planar region;
a channel gate over the fin region and the planar region; and
a drain extension region in the planar region between the source region and the drain region.

2. The LDFET of claim 1, further comprising a first gate dielectric between the channel gate and the fin region and a second gate dielectric between the channel gate and the planar region.

3. The LDFET of claim 2, wherein the first and second gate dielectrics include an in-situ steam generated (ISSG) oxide and have a same, uniform thickness over the fin region and the planar region.

4. The LDFET of claim 2or 3, wherein the second gate dielectric is thicker than the first gate dielectric.

5. The LDFET of one of claims 2 to 4, wherein the first gate dielectric includes an in-situ steam generated (ISSG) oxide in the fin region and the second gate dielectric includes a local oxidation of silicon (LOCOS) oxide in the planar region, wherein the ISSG oxide has a uniform thickness and the LOCOS oxide has a non-uniform thickness.

6. The LDFET of one of claims 1 to 5, further comprising a trench isolation (TI) in the planar region between the drain extension region and the drain region, wherein the channel gate extends partially over the trench isolation.

7. The LDFET of one of claims 1 to 6, further comprising a deep trench isolation (DTI) in the planar region between the drain extension region and the drain region, wherein the channel gate extends partially over the DTI, wherein the DTI includes a local oxidation of silicon (LOCOS) oxide.

8. The LDFET of claim 7, further comprising a trench isolation (TI) in the planar region between the drain extension region and the drain region, wherein the channel gate extends partially over the trench isolation.

9. The LDFET of one of claims 1 to 8, further comprising:
a channel in the fin region under the channel gate; and
a first gate dielectric between the channel gate and the fin region and a second gate dielectric between the channel gate and the planar region,
wherein the drain extension region is formed in the planar region between the channel and the drain region.

10. A method, comprising:
forming a substrate having a fin region and a planar region adjacent the fin region;
forming a source region in the fin region;
forming a drain region in the planar region; and
forming a channel gate over the fin region and the planar region, creating a channel in the fin region under the channel gate and a drain extension region in the planar region between the channel and the drain region,
wherein forming the channel gate includes forming a first gate dielectric between a body of the channel gate and the fin region and forming a second gate dielectric between the body of the channel gate and the planar region.

11. The method of claim 10, wherein forming the first gate dielectric and the second gate dielectric includes using an in-situ steam generated (ISSG) oxide process in the fin region and the planar region.

12. The method of claim 10 or 11, wherein the second gate dielectric in the planar region is thicker than the first gate dielectric in the fin region.

13. The method of claim 12, wherein forming the first gate dielectric includes using an in-situ steam generated (ISSG) oxide process in the fin region, and forming the second gate dielectric includes using a local oxidation of silicon (LOCOS) oxide process in the planar region.

14. The method of one of claims 10 to 13, further comprising forming a trench isolation in the planar region between the drain extension region and the drain region.

15. The method of one of claims 10 to 14, wherein the LDFET of one of claims 1 to 9 is formed.
